(19)  Europäisches Patentamt

**European Patent Office**  (11) Numéro de publication : **0 069 608**

Office européen des brevets                                      **B1**

(12)                   **FASCICULE DE BREVET EUROPÉEN**

(45) Date de publication du fascicule du brevet :   (51) Int. Cl.⁴ : **H 01 S   3/19, H 01 L 33/00**
20.02.85

(21) Numéro de dépôt : **82401038.3**

(22) Date de dépôt : **08.06.82**

(54) **Laser à semiconductor à courte longueur d'onde.**

(30) Priorité : **19.06.81 FR 8112143**

(43) Date de publication de la demande :
**12.01.83 Bulletin 83/02**

(45) Mention de la délivrance du brevet :
**20.02.85 Bulletin 85/08**

(84) Etats contractants désignés :
**DE GB NL**

(56) Documents cités :
**EP-A- 0 038 981**
**DE-A- 2 001 870**
**IEEE TRANSACTIONS ON ELECTRON DEVICES, vol. ED-26, no. 8, août 1979, IEEE NEW YORK (US) O.N. ERMAKOV et al.: "Yellow-Green In1-xGaxP and In1-xGaxP1-zAsz LED's and Electron-Beam-Pumped Lasers Prepared by LPE and VPE" pages 1190-1193**

(73) Titulaire : **THOMSON-CSF**
**173, Boulevard Haussmann**
**F-75379 Paris Cedex 08 (FR)**

(72) Inventeur : **di Forte-Poisson, Marie-Antoinette**
**THOMSON-CSF SCPI 173, bld Haussmann**
**F-75379 Paris Cedex 08 (FR)**
Inventeur : **Hirtz, Jean-Pierre**
**THOMSON-CSF SCPI 173, bld Haussmann**
**F-75379 Paris Cedex 08 (FR)**
Inventeur : **Duchemin, Jean-Pascal**
**THOMSON-CSF SCPI 173, bld Haussmann**
**F-75379 Paris Cedex 08 (FR)**
Inventeur : **de Cremoux, Baudoin**
**THOMSON-CSF SCPI 173, bld Haussmann**
**F-75379 Paris Cedex 08 (FR)**

(74) Mandataire : **Lepercque, Jean et al**
**THOMSON-CSF SCPI 173, Bld Haussmann**
**F-75379 Paris Cedex 08 (FR)**

Jouve, 18, rue St-Denis, 75001 Paris, France

## Description

L'invention concerne un laser à semiconducteur (diode laser) permettant l'obtention d'un rayonnement à longueur d'onde relativement petite par rapport aux longueurs d'onde usuelles des lasers à semiconducteurs.

En effet, la plus petite longueur d'onde obtenue avec des diodes lasers à semiconducteurs est de l'ordre de 0,8 μm, donc située dans l'infrarouge. L'invention permet, par contre, d'atteindre le domaine de la lumière visible, ce qui présente les avantages suivants :

1. La possibilité de contrôle visuel ;

2. L'amélioration de la résolution des systèmes optiques, notamment des lecteurs de vidéodisque, audiodisque et disque optique dans la mesure où la résolution est limitée par le phénomène de diffraction.

Dans ces applications, on focalise le rayonnement du laser sur la surface du disque. Le rayon de la tache de focalisation est donné en fonction de la longueur d'onde et de l'ouverture numérique (sin U) par la formule :

$$R = 0{,}61 \ \lambda/\sin U$$

Pour augmenter la résolution, il faut diminuer R donc :

soit diminuer la longueur d'onde, ce qui est l'objet de la présente invention ;

soit augmenter l'ouverture numérique ce qui entraîne une augmentation des aberrations proportionnelles à la puissance quatrième de U, d'où l'inconvénient de devoir les corriger à l'aide de systèmes optiques très performants donc très coûteux.

Il y a donc avantage à diminuer en priorité la longueur d'onde émise par le laser à semiconducteurs.

Le laser selon l'invention comporte un substrat en Ga As, d'un type de conductivité prédéterminé, et au moins les couches épitaxiales suivantes : une première couche de confinement de même type de conductivité que le substrat, une couche active et une deuxième couche de confinement d'un type opposé de conductivité ; les couches de confinement étant constituées de matériaux à bande interdite plus large que celle de la couche active.

Il est caractérisé en ce que le matériau constituant la couche active est en alliage répondant à l'une des formules :

$$Ga_xIn_{1-x}As_yP_{1-y} \tag{1}$$

où x est compris entre zéro et un, y est nul ou compris entre zéro et un, x et y étant liés entre eux par la relation, vérifiée à 1 % près :

$$y = (0{,}42 \ x - 0{,}22)/(0{,}01 \ x + 0{,}19) \tag{I}$$

ou :

$$Ga_xAl_zIn_{1-x-z}P \tag{2}$$

où x est compris entre zéro et un, z est nul ou compris entre zéro et un, x et z étant liés entre eux par la relation, vérifiée à 1 % près :

$$z = (0{,}22 - 0{,}42 \ x)/(0{,}41 + 5{,}04 \ x) \tag{II}$$

En outre, il est caractérisé en ce que les couches de confinement sont en alliage répondant à la formule :

$$In_{z'}Al_{1-z'}P \tag{3}$$

avec :

$$0{,}45 \leqslant z' \leqslant 0{,}49 \tag{III}$$

L'invention sera mieux comprise, et d'autres caractéristiques apparaîtront, au moyen de la description qui suit, et des dessins qui l'accompagnent, parmi lesquels :

Les figures 1 et 2 représentent des réalisations de l'invention ;

La figure 3 est un diagramme explicatif.

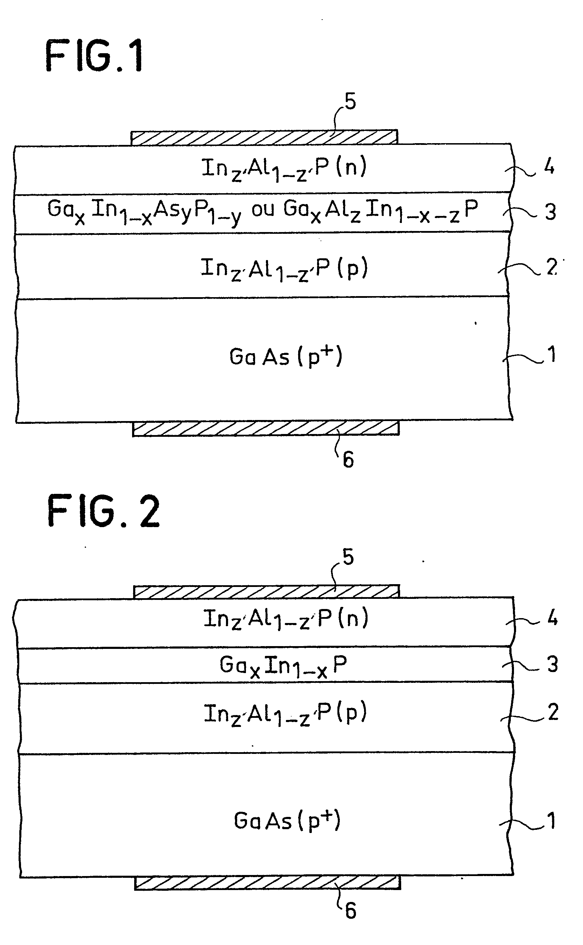

Sur les figures 1 et 2, on a représenté, en coupe partielle et schématique, un dispositif semiconducteur selon l'invention comportant un substrat 1 en arséniure de gallium, supportant une couche de confinement 2, une couche active 3, une autre couche de confinement 4, enfin des métallisations 5 et 6 formant des contacts ohmiques avec le matériau des faces extrêmes. Ces métallisations sont destinées à permettre un bon raccordement à une source de tension électrique.

Dáns tous les cas représentés, le substrat est en Ga As dopé $p^+$. Un dopage $n^+$, également possible, correspond à une autre série d'exemples, non représentés, où les dopages des diverses couches et du substrat seraient de type opposé de conductivité, la source de tension ayant alors des polarités inversées.

Sur l'exemple de la figure 1, les caractéristiques des couches sont les suivantes :

Couches 2 et 4 : en alliage de formule :

$$In_{z'}Al_{1-z'}P$$

dans laquelle z satisfait aux relations (III) citées plus haut.

En outre la couche 2 est dopée p et la couche 4 dopée n.

Couche 3 : en alliage de composition donnée par l'une des formules (1) et (2), x et y, ou x et z, selon le cas satisfont aux diverses conditions posées ci-avant, en particulier les relations (I) et (II). Ces relations sont nécessaires pour permettre une bonne croissance épitaxiale, lors de la fabrication du dispositif par épitaxie, des couches de différfentes compositions sur un même substrat en Ga As. Elles expriment le fait que les paramètres des réseaux cristallins doivent être égaux à 1 ou 2 % près.

Sur l'exemple de la figure 2, les caractéristiques des couches sont les suivantes :

Couches 2 et 4 : en alliage de même composition et de même dopage que les couches 2 et 4 de la figure 1.

Couche 3 : alliage de composition :

$$Ga_xIn_{1-x}P$$

formule qui correspond au cas de :

$$y = z = 0$$

La couche 3 peut être dopée n ou p.

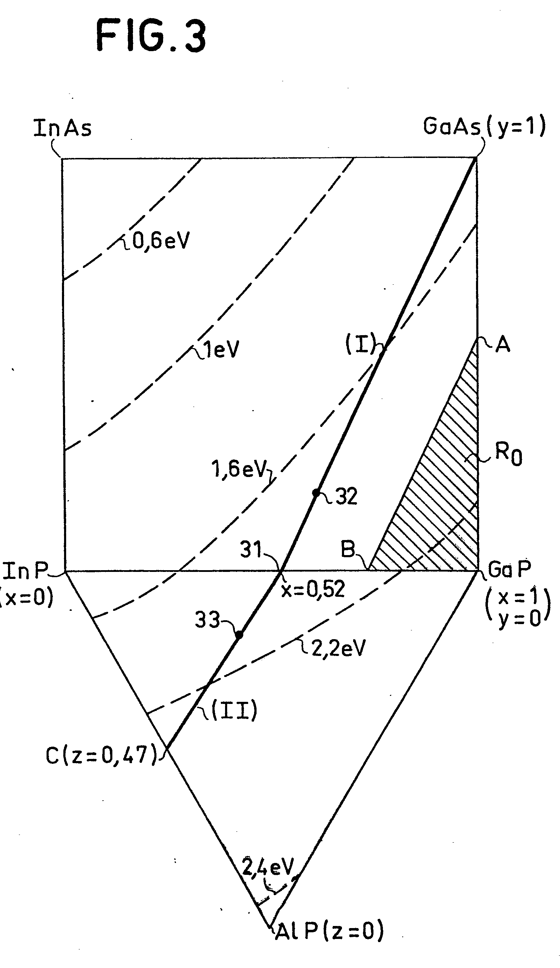

Pour expliquer le fonctionnement de la diode laser dans le dispositif représenté à la figure 1 ou 2, on fait appel d'abord aux connaissances générales d'ordre classique puis au diagramme de la figure 3.

D'après les conditions générales de fonctionnement des diodes laser, la couche active doit être réalisée en composé dit III-V (formé d'éléments des troisième et cinquième colonnes de la table de Mendéleeff). C'est le cas des alliages des couches 3 des dispositifs des figures 1 et 2. En outre, cette couche active doit être bordée par deux couches dites de confinement en matériau présentant une largeur de bande interdite plus grande que celle du matériau constituant la couche active. Ce point sera vérifié à la figure 3.

En effet, on a représenté, à la figure 3, deux diagrammes accolés d'alliages quaternaires :

un diagramme carré joignant les points figuratifs des quatre alliages In As, Ga As, Ga P et In P ;

un diagramme triangulaire dont les trois sommets sont les points figuratifs des composés In P, Ga P et Al P.

Les deux diagrammes, accolés par le segment In P-Ga P, délimitent deux espaces dans lesquels les points figuratifs représentent :

un alliage $Ga_xIn_{1-x}As_yP_{1-y}$ dans la carré, les valeurs de x et de y étant déterminées par les distances du point figuratif aux segments In P-In As (pour x) et In P-Ga P (pour y) ;

un alliage $Ga_xAl_zIn_{1-x-z}P$ dans le triangle, les valeurs de x et de z étant mesurées sur des lignes parallèles aux bases In P-Ga P (pour x) et Al P-In P (pour z).

En outre, on a tracé, en trait tireté, des lignes sur lesquelles la largeur de bande interdite reste constante lorsqu'on se déplace dans le diagramme. On constate que la largeur de bande interdite croît lorsqu'on se déplace du sommet In As, au voisinage duquel la largeur de bande interdite est inférieure à 0,6 électron-volt, en allant vers le sommet Al P au voisinage duquel la largeur de bande interdite est voisine de 2,4 eV.

Enfin on a délimité par un segment de droite AB une région $R_0$ du diagramme carré, dans laquelle les transitions du matériau semiconducteur sont du type indirect. Dans cette région, il n'y a pas possibilité de constituer un laser ayant une couche active dont le matériau ait une composition correspondant à un point de la région.

On a représenté par les points figuratifs 31, 32 et 33 sur le diagramme de la figure 3 :

1. En 31, d'abscisse x = 0,52 sur la droite In P-Ga P, une composition de la couche active d'un laser conforme à celui de la figure 2 ;

2. En 32, (x = 0,6 ; y = 0,2) une composition de couche active de laser conforme à la figure 1, dans le cas d'un alliage de formule (1). Ce point figuratif se trouve sur la droite (I) joignant le sommet Ga As du carré au point 31. L'équation de la droite (I) dans le système de coordonnées x et y n'est autre que la relation (I) ;

3. En 33 (x = 0,34 ; z = 0,4) une composition de couche active de laser conforme à la figure 1, dans le cas d'un alliage de formule (2). Ce point figuratif se trouve sur la droite (II) joignant le point 31 au point C, point figuratif de l'alliage de composition :

$$In_{0,47}Al_{0,53}P$$

qui est celui des couches de confinement (0,47 étant la valeur médiane de l'intervalle des valeurs de z définies par la relation (III)).

Il apparaît nettement que les lasers possédant des couches actives de compositions représentées par les points 31, 32 et 33 ont une longueur d'onde d'autant plus petite que leur bande interdite est plus grande, c'est-à-dire que l'on se rapproche du point C sur la droite In P-Al P.

Une couche active de composition correspondant au point 31 a une largeur de bande interdite de 1,9 eV, ce qui correspond à une longueur d'onde d'émission de 0,65 $\mu$m.

**Revendications**

1. Laser à semiconducteur émettant en lumière visible, du type comportant un substrat (1) en Ga As, d'un type de conductivité prédéterminé, et au moins les couches épitaxiales suivantes : une première couche (2) de confinement de même type de conductivité que le substrat, une couche active (3) et une deuxième couche (4) de confinement d'un type opposé de conductivité ; les couches de confinement étant constituées de matériaux à bande interdite plus large que celle de la couche active, le laser étant caractérisé en ce que le matériau constituant la couche active est en alliage répondant à la formule :

$$Ga_xIn_{1-x}As_yP_{1-y} \qquad (1)$$

où x est compris entre zéro et un, y est nul ou compris entre zéro et un, x et y étant liés entre eux par la relation, vérifiée à 1 % près :

$$y = (0,42\ x - 0,22)/(0,01\ x + 0,19) \qquad (I)$$

et en ce que les couches de confinement sont en alliage répondant à la formule :

$$In_{z'}Al_{1-z'}P \qquad (3)$$

avec :

$$0,45 \leqslant z' \leqslant 0,49 \qquad (III)$$

2. Laser à semiconducteur émettant en lumière visible, du type comportant un substrat (1) en Ga As, d'un type de conductivité prédéterminé, et au moins les couches épitaxiales suivantes : une première couche (2) de confinement de même type de conductivité que le substrat, une couche active (3) et une deuxième couche (4) de confinement d'un type opposé de conductivité ; les couches de confinement étant constituées de matériaux à bande interdite plus large que celle de la couche active, le laser étant caractérisé en ce que le matériau constituant la couche active est en alliage répondant à la formule :

$$Ga_xAl_zIn_{1-x-z}P \qquad (2)$$

où x est compris entre zéro et un, z est nul ou compris entre zéro et un, x et z étant liés entre eux par la relation, vérifiée à 1 % près :

$$z = (0,22 - 0,42\ x)/(0,41 + 5,04\ x) \qquad (II)$$

et en ce que les couches de confinement sont en alliage répondant à la formule :

$$In_{z'}Al_{1-z'}P \qquad (3)$$

avec :

$$0,45 \leqslant z' \leqslant 0,49 \qquad (III)$$

3. Laser selon la revendication 1 et 2, caractérisé en ce que le matériau constituant la couche active a la composition suivante :

$$Ga_xIn_{1-x}P$$

avec :

$$0,51 \leqslant x \leqslant 0,53.$$

**Claims**

1. Semi-conductor laser, emitting in visible light, of the type having a substrate (1) in GaAs, of a predetermined conductivity type, and at least the following epitaxial layers : a first confinement layer (2) of the same type of conductivity as the substrate, an active layer (3) and a second confinement layer (4) with an opposite type of conductivity ; the confinement layers being composed of material with a prohibited band broader than that of the active layer, the laser being characterized in that the material constituting the active layer is in an alloy having the formula :

$$Ga_xIn_{1-x}As_yP_{1-y} \tag{1}$$

wherein x is comprised between zero and one, y is zero or comprised between zero and one, x and y being related to each other by the relation, verified with 1 % precision :

$$y = (0,42\,x - 0,22)/(0,01\,x + 0,19) \tag{I}$$

and in that the confinement layers are in alloy with the formula :

$$In_{z'}Al_{1-z'}P \tag{3}$$

with :

$$0,45 \leqslant z' \leqslant 0,49 \tag{III}$$

2. Semi-conductor laser emitting in visible light, of the type comprising a substrate (1) in GaAs, of a predetermined conductivity type, and at least the following epiaxial layers : a first confinement layer (2) of the same type of conductivity as the substrate, an active layer (3) and a second confinement layer (4) of opposed type of conductivity, the layers of confinement being composed of material with a prohibited band broader than those of the active layer, the laser being characterized in that the material constituting the active layer is in alloy with the formula :

$$Ga_xAl_zIn_{1-x-z}P \tag{2}$$

wherein x is comprised between zero and one, z being zero or comprised between zero and one, x and z being related to each other by the relation, verified at 1 % precision :

$$z = (0,22 - 0,42\,x)/(0,41 + 5,04\,x) \tag{II}$$

in that the confinement layers are in alloy responding to the formula :

$$In_{z'}Al_{1-z'}P \tag{3}$$

with :

$$0,45 \leqslant z' \leqslant 0,49 \tag{III}$$

3. Laser according to one of claims 1 and 2, characterized in that the material constituting the active layer has the following composition :

$$Ga_xIn_{1-x}P$$

with :

$$0,51 \leqslant x \leqslant 0,53.$$

**Ansprüche**

1. Halbleiterlaser, der in sichtbares Licht emittiert, und der eine GaAs (1) Grundlage eines vorbestimmten Leitungsfähigkeitstyps und wenigstens die folgenden epitachsischen Schichten enthält : eine erste Einschränkungsschicht (2) des Leitungsfähigkeitstyps der Grundlage, eine aktive Schicht (3) und eine zweite Einschränkungsschicht (4) eines entgegengesetzten Leitungsfähigkeitsttyps, wobei die Einschränkungsschichten aus Material mit verbotenem Band breiter als die der aktiven Schicht gebildet sind, dadurch gekennzeichnet, dass das die aktive Schicht bildende Material eine Legierung ist die der folgenden Formel entspricht :

$$Ga_xIn_{1-x}As_yP_{1-y} \tag{1}$$

in dem x zwischen Null und Eins einbegriffen ist, y Null ist oder zwischen Null und Eins einbegriffen ist, wobei x und y durch die folgende Gleichung mit einer 1 % Genauigkeit miteinander verbunden sind :

$$y = (0,45\, x - 0,22)/(0,01\ x + 0,19) \tag{I}$$

und indem die Einschränkungsschichten in Legierung sind und der folgenden Formel entsprechen :

$$In_{z'}Al_{1-z'}P \tag{3}$$

mit

$$0,45 \leqslant z' \leqslant 0,49 \tag{III}$$

2. Halbleiterlaser, der in sichtbares Licht emittiert, und der eine GaAs Grundlage (1) eines vorbestimmten Leitungsfähigkeitstyps und wenigstens die folgenden epitachsischen Schichten enthält : eine erste Einschränkungsschicht (2) des Leitungsfähigkeitstyps der Grundlage, eine aktive Schicht (3) und eine zweite Einschränkungsschicht (4) eines entgegengesetzten Leitungsfähigkeitsttyps, wobei die Einschränkungsschichten aus Material mit verbotenem Band breiter als die der aktiven Schicht gebildet sind, dadurch gekennzeichnet, dass das die aktive Schicht bildende Material eine Legierung ist und die der folgenden Formel entspricht :

$$Ga_xAl_zIn_{1-z-x}P$$

in dem x zwischen Null und Eins einbegriffen ist, z Null ist oder zwischen Null und Eins einbegriffen ist, wobei x und z durch die folgende Gleichung mit einer 1 % Genauigkeit miteinander verbunden sind :

$$z = (0,22 - 0,42\ x)/(0,41 + 5,04\ x) \tag{II}$$

und indem die Einschränkungsschichten in Legierung sind un der folgenden Formel entsprechen :

$$In_{z'}Al_{1-z'}P \tag{3}$$

mit

$$0,45 \leqslant z' \leqslant 0,49 \tag{III}$$

3. Laser nach einem der Ansprüche 1 und 2, dadurch gekennzeichnet, dass der die aktive Schicht bildender Material der folgenden Formel entspricht :

$$Ga_xIn_{1-x}P$$

mit

$$0,51 \leqslant x \leqslant 0,53.$$

# FIG.1

$In_{z'}Al_{1-z'}P$ (n) — 4

$Ga_x In_{1-x}As_yP_{1-y}$ ou $Ga_x Al_z In_{1-x-z}P$ — 3

$In_{z'}Al_{1-z'}P$ (p) — 2

Ga As (p⁺) — 1

5

6

# FIG. 2

$In_{z'}Al_{1-z'}P$ (n) — 4

$Ga_x In_{1-x}P$ — 3

$In_{z'}Al_{1-z'}P$ (p) — 2

GaAs (p⁺) — 1

5

6

# FIG.3